# EUROPEAN PATENT SPECIFICATION

(11) **EP 0 803 326 B1**
(45) Date of publication and mention of the grant of the patent: **02.10.2002**
(21) Application number: 97106937.2
(22) Date of filing: 25.04.1997
(51) Int. Cl.: B24B 37/04, B24B 55/00, B23Q 11/08, H01L 21/304

(54) **Polishing apparatus**
Poliervorrichtung
Dispositif de polissage

(30) Priority: 26.04.1996 JP 13098796; 28.05.1996 JP 15760896
(43) Date of publication of application: 29.10.1997
(73) Proprietor: EBARA CORPORATION, Ohta-ku, Tokyo (JP); KABUSHIKI KAISHA TOSHIBA, Kawasaki-shi, Kanagawa-ken 210-8572 (JP)
(72) Inventor: Togawa, Tetsuji, Chigasaki-shi, Kanagawa-ken (JP); Yamaguchi, Kuniaki, Yokohama-shi, Kanagawa-ken (JP); Sakurai, Kunihiko, Yokohama-shi, Kanagawa-ken (JP); Yajima, Hiromi, Yokohama-shi, Kanagawa-ken (JP)
(74) Representative: Wagner, Karl H., Dipl.-Ing.

(56) References cited:
- DE-A- 19 544 328
- US-A- 5 036 625

## Description

### BACKGROUND OF THE INVENTION

### Field of the Invention:

The present invention relates to a polishing apparatus for polishing a workpiece such as a semiconductor wafer to a flat mirror finish, and more particularly to a polishing apparatus having an easy maintenance characteristic.

### Description of the Related Art:

Recent rapid progress in semiconductor device integration demands smaller and smaller wiring patterns or interconnections and also narrower spaces between interconnections which connect active areas. One of the processes available for forming such interconnection is photolithography. Though the photolithographic process can form interconnections that are at most 0.5 µm wide, it requires that surfaces on which pattern images are to be focused by a stepper be as flat as possible because the depth of focus of the optical system is relatively small.

It is therefore necessary to make the surfaces of semiconductor wafers flat for photolithography. One customary way of flattening the surfaces of semiconductor wafers is to polish them with a polishing apparatus, and such a process is called Chemical Mechanical polishing.

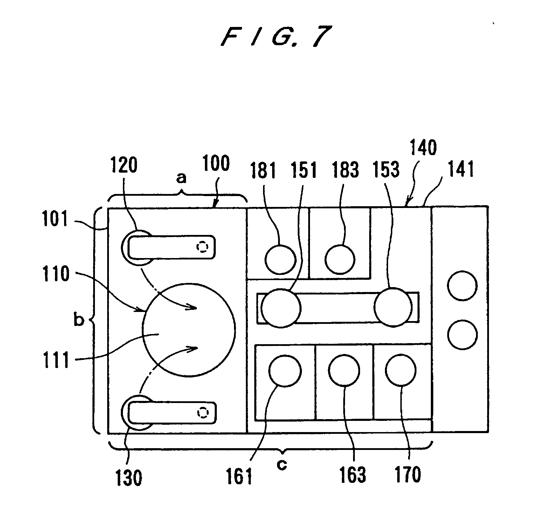

FIG. 7 shows one conventional polishing apparatus having a polishing section 100 for polishing semiconductor wafers. The polishing section 100 comprises a turntable 110 having a polishing surface 111 and rotatable about its own axis at a predetermined speed, a top ring 120 for holding a semiconductor wafer to rotate the semiconductor wafer at a predetermined speed and pressing the semiconductor wafer against the polishing surface 111 of the turntable 110 for thereby polishing a surface of the semiconductor wafer, and a dressing tool 130 for dressing the polishing surface 111 to regenerate the polishing surface in contact therewith. The turntable 110, the top ring 120, and the dressing tool 130 are housed in a single chamber 101.

The polishing apparatus also has a cleaning section 140 for conveying the semiconductor wafers and cleaning the semiconductor wafers. The cleaning section 140 comprises two workpiece conveying robots 151, 153 for taking a semiconductor wafer out of a cassette and delivering the semiconductor wafer to the polishing section 100, primary and secondary cleaning devices 161, 163 for cleaning the semiconductor wafer which has been polished, a drying device 170 for drying the semiconductor wafer which has been cleaned, and two workpiece reversing devices 181, 183 for reversing the semiconductor wafer upside down. The workpiece conveying robots 151, 153, the primary and secondary cleaning devices 161, 163, the drying device 170, and the workpiece reversing devices 181, 183 are housed in a single chamber 141.

Certain parts of the top ring 120, a polishing cloth which provides the polishing surface 111 of the turntable 110, and a dressing element such as a dresser brush or a diamond grain layer on the dressing tool 130 are expendable articles or parts that should be replaced with new ones periodically in maintenance activities.

The cleaning devices 161, 163 also have expendable articles including cleaning brushes and sponge elements which are also required to be replaced with new ones periodically in maintenance activities.

The above maintenance activities signify not service repair activities for repairing the polishing section 100 and the cleaning section 140 in the event of malfunctions or failures, but periodical replacement routines for replacing expendable articles or parts.

Heretofore, the maintenance activities which involve parts replacement have been carried out in three different side faces, i.e., a side face "a" for maintenance such as replacement of the parts of the top ring 120, a side face "b" for maintenance such as replacement of the polishing cloth constituting the polishing surface 111, and a side face "c" for maintenance such as replacement of the dresser brush of the dressing tool 130 and the cleaning brushes of the cleaning devices 161, 163.

Because of these three side faces "a", "b" and "c" involved, it has been necessary to keep empty spaces respectively in front of the side faces "a", "b" and "c" to allow approach to the side faces "a", "b" and "c" for maintenance such as the replacement of parts. Consequently, any one of these side faces "a", "b" and "c" cannot be positioned closely to other hindering objects such as walls or pillars, with the result that a large installation space has been required for the installation of the polishing apparatus.

When the polishing apparatus is to be maintained or serviced successively at the side faces "a", "b" and "c", the person for maintenance has to move from one side face to another while carrying tools and parts. Therefore, the maintenance work of the polishing apparatus has been troublesome and time-consuming.

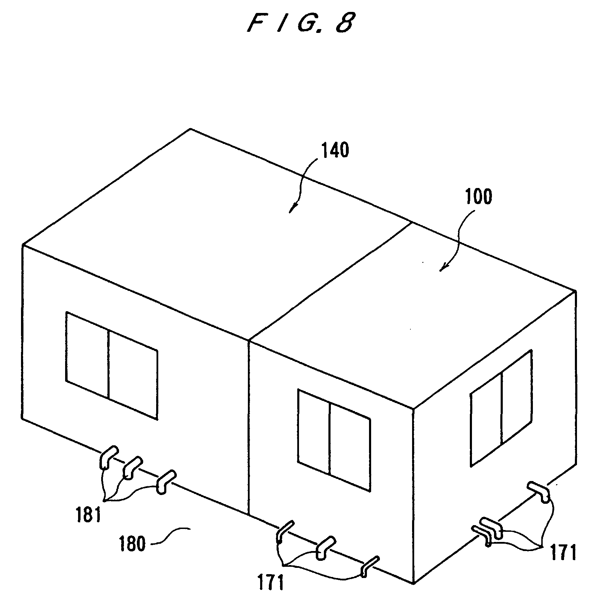

FIG. 8 is a perspective view showing an outer appearance of the conventional polishing apparatus shown in FIG. 7. As shown in FIG. 8, the polishing section 100 and the cleaning section 140 are housed in respective chambers in the form of a rectangular parallelepiped.

The polishing section 100 and the cleaning section 140 have a number of pipes 171, 181 extending from side walls of the chambers for supplying liquid to and discharging liquid from the various units and machines in the polishing section 100 and the cleaning section 140. The pipes 171, 181 extend vertically through a floor 180 into a machinery room (not shown) below the floor 180, and are connected to various devices in the machinery room.

Heretofore, the pipes 171, 181 projecting out of the chambers are randomly located, and cause various problems described below.

Since the pipes 171, 181 project from the side walls of the chambers, they present obstacles when the polishing section 100 and the cleaning section 140 are maintained, or transported for installation thereof. When the pipes 171, 181 are damaged or broken by collision with operators or other objects, they give rise to safety problems.

The installation work of the polishing apparatus on the floor 180 is troublesome and time-consuming because the floor 180 has to be drilled to make holes for insertion of the pipes 171, 181.

The pipes 171, 181 project from the side walls of the chambers into passages around the chambers and tend to obstruct operators walking along the passages. Therefore, the pipes 171, 181 make the polishing apparatus take up a more installation space than would be required by their physical size. In addition, the pipes 171, 181 are not sightly to external view.

US-A-5 655 954 discloses a polishing apparatus which comprises a polishing mechanism for polishing a wafer taken out from a cassette, an attaching-detaching device for attaching to and detaching the wafer from the polishing mechanism, a device for cleaning the polished wafer, and a transportation device for transporting the wafer between the cassette, polishing mechanism, attaching-detaching device, and cleaning device. These devices are arranged individually in compartments. A working chamber is divided into a plurality of compartments by means of partitioning devices. A device for polishing a workpiece is set in one of the compartments. The apparatus is also provided with communication devices for internally connecting the adjacent compartments which are divided by the partitioning devices. The apparatus may further comprise devices for individually controlling the respective internal pressures of the compartments or a device for generating an air flow in the form of a laminar flow in each of the compartments.

US-A-5 036 625 relates to a complete double lap lapping and polishing machine and particularly to an apparatus designed to finish to a required thickness and/or finished polish workpiece such as thin silicon and/or ceramic wafers. The machine includes substructure components, including overall housing design, planetary gear drive, fluid cooling systems, positioning and locking of the upper lap plate in an inoperative position, an automatic thickness or sizing control, rotary union with automatic fluid liquid indicator and a slurry delivery and recovery system.

### SUMMARY OF THE INVENTION

It is therefore an object of the present invention to provide a polishing apparatus which allows the person for maintenance to easily perform maintenance activities such as replacement of various expendable articles or parts, and which can be installed in a relatively small installation space.

According to one aspect of the present invention, there is provided the polishing apparatus defined in claim 1.

According to another aspect of the present invention, there is provided the polishing apparatus defined in claim 3.

The above and other objects, features, and advantages of the present invention will become apparent from the following description when taken in conjunction with the accompanying drawings which illustrate preferred embodiments of the present invention by way of examples.

### BRIEF DESCRIPTION OF THE DRAWINGS

FIG. 1 is a schematic plan view of a polishing apparatus according to a first embodiment of the present invention;
FIG. 2 is a cross-sectional view of a polishing section of the polishing apparatus;
FIG. 3 is a schematic plan view of a polishing apparatus according to a second embodiment of the present invention;
FIG. 4 is a perspective view showing an outward appearance of the polishing apparatus according to the second embodiment of the present invention;
FIG. 5 is a schematic plan view showing an arrangement of pipes according to the second embodiment of the present invention;
FIG. 6 is a schematic vertical cross-sectional view showing an arrangement of a polishing apparatus and a machinery room;
FIG. 7 is a schematic plan view of a conventional polishing apparatus; and
FIG. 8 is a perspective view showing an outward appearance of the conventional polishing apparatus shown in FIG. 7.

### DETAILED DESCRIPTION OF THE PREFERRED EMBODIMENT

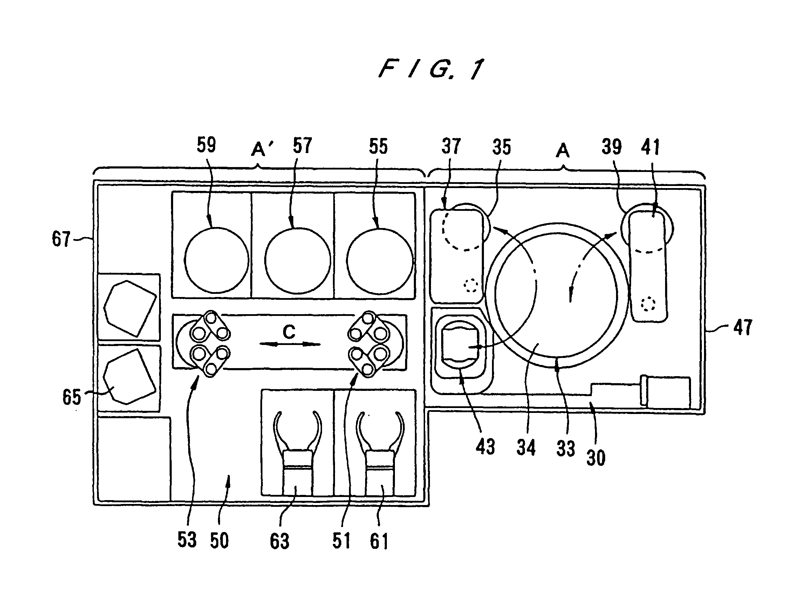

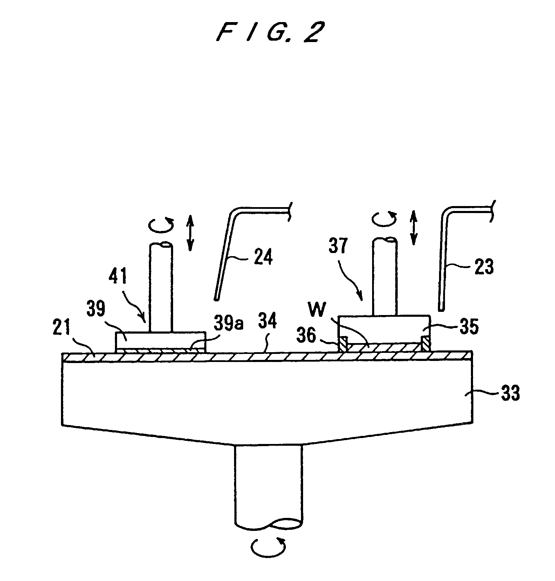

A polishing apparatus according to a first embodiment of the present invention will be described below with reference to FIGS. 1 and 2.

As shown in FIG. 1, a polishing apparatus comprises a polishing section 30 for polishing a workpiece such as a semiconductor wafer, and a cleaning section 50 for cleaning the workpiece which has been polished in the polishing section 30. The polishing section 30 comprises a central turntable 33, a polishing unit 37 disposed on one side of the turntable 33 and having a top ring 35, a dressing unit 41 disposed on the other side of the turntable 33 and having a dressing tool 39, and a workpiece transfer device 43 for transferring the workpiece between the top ring 35 and the workpiece transfer device 43. The turntable 33, the polishing unit 37, the dressing unit 41, and the workpiece transfer unit 43 are all housed in a single chamber 47 which is enclosed by walls.

In FIG. 1, the top ring 35 is shown as being in a maintenance position therefor, and the dressing tool 39 is also shown as being in a maintenance position therefor. When the top ring 35 and the dressing tool 39 are in their respective maintenance positions, they are positioned closely to a side face A of the polishing section 30. The polishing surface 34 of the turntable 33 is also positioned closely to the side face A.

In the illustrated embodiment, only the side face A of the polishing section 30, among a plurality of side faces of the chamber 47, serves as a maintenance face which is easily approachable for maintenance of the polishing section 30. A door (not shown) for maintenance is provided at the side face A.

The cleaning section 50 comprises a pair of central workpiece conveying robots 51, 53 movable in the directions indicated by the arrow C, primary and secondary cleaning devices 55, 57 and a spinning drier 59 which are arranged in an array on one side of the workpiece conveying robots 51, 53, and two workpiece reversing devices 61, 63 which are arranged in an array on the other side of the workpiece conveying robots 51, 53. The workpiece conveying robots 51, 53, the primary and secondary cleaning devices 55, 57 and the spinning drier 59, and the workpiece reversing devices 61, 63 are housed in a single chamber 67 which is enclosed by walls.

The primary and secondary cleaning devices 55, 57 and the spinning drier 59 are positioned closely to a side face A' of the cleaning section 50. In the illustrated embodiment, only the side face A' of the cleaning section 50, among a plurality of side faces of the chamber 67, serves as a maintenance face which is easily approachable for maintenance of the cleaning section 50. A door (not shown) for maintenance is provided at the side face A'. The side face A' of the cleaning section 50 is aligned with or lies flush with the side face A of the polishing apparatus 30. That is, the polishing section 30 and the cleaning section 50 have a common side face comprising the side faces A and A' for approaching an interior thereof for maintenance of the polishing section 30 and the cleaning section 50.

FIG. 2 shows the polishing section 30 having the turntable 33, the top ring unit 37 and the dressing unit 41. The top ring unit 37 has the top ring 35 for supporting a semiconductor wafer W and pressing the semiconductor wafer W against the turntable 33. The turntable 33 is rotatable about its own axis as indicated by an arrow by a motor (not shown) which is coupled to the turntable 33. A polishing cloth 21 constituting a polishing surface 34 is attached to an upper surface of the turntable 33.

The top ring 35 is coupled to a motor (not shown) and also to a lifting/lowering cylinder (not shown). The top ring 35 is vertically movable and rotatable about its own axis as indicated by the arrows by the motor and the lifting/lowering cylinder. The top ring 35 can therefore press the semiconductor wafer W against the polishing cloth 21 under a desired pressure. The semiconductor wafer W is attached to a lower surface of the top ring 35 under a vacuum or the like. A guide ring 36 is mounted on the outer circumferential edge of the lower surface of the top ring 35 for preventing the semiconductor wafer W from being disengaged from the top ring 35. An abrasive liquid is supplied through a supply pipe 23 onto the polishing cloth 21.

A dressing unit 41 comprises a dressing tool 39 which is positioned above the turntable 33 in diametrically opposite relation to the top ring 35. A dressing liquid is supplied through a supply pipe 24 onto the polishing cloth 21. The dressing tool 39 is coupled to a motor (not shown) and also to a lifting/lowering cylinder (not shown). The dressing tool 39 is vertically movable and rotatable about its own axis as indicated by the arrows by the motor and the lifting/lowering cylinder. The dressing tool 39 has a dressing element 39a composed of, for example, nylon brush, or a diamond grain layer containing diamond grains on its lower surface.

Operation of the polishing apparatus comprising the polishing section 30 and the cleaning section 50 will be described below.

When a wafer cassette 65 which houses a plurality of semiconductor wafers to be polished is set in a position as shown in FIG. 1, the workpiece conveying robot 53 takes a semiconductor wafer out of the cassette 65, and transfers the semiconductor wafer to the workpiece reversing device 63. After the semiconductor wafer is reversed, i.e., turned upside down, by the workpiece reversing device 63, it is received by the workpiece conveying robot 51, and then placed onto the workpiece transfer device 43 through an opening formed in a partition between chambers by the workpiece conveying robot 51.

Thereafter, the top ring 35 of the polishing unit 37 is angularly displaced as indicated by the dot-and-dash line to a position directly above the workpiece transfer device 43. The semiconductor wafer on the workpiece transfer device 43 is lifted to a position near a lower surface of the top ring 35, and then attached to the top ring 35 under vacuum developed by a vacuum pump or the like (not shown).

Then, the top ring 35 is moved over the turntable 33, and presses the semiconductor wafer against the polishing surface 34 on the turntable 33. While the turntable 33 and the top ring 35 are rotated independently of each other, the lower surface of the semiconductor wafer is polished to a flat mirror finish. At this time, the abrasive liquid is supplied through the supply pipe 23 onto the polishing surface 34. After the semiconductor wafer is polished, the top ring 35 is moved back over the workpiece transfer device 43, and transfers the polished semiconductor wafer onto the workpiece transfer device 43.

The semiconductor wafer placed on the workpiece transfer device 43 is then held by the workpiece conveying robot 51, and transferred therefrom to the workpiece reversing device 61. The workpiece reversing device 61 reverses the semiconductor wafer. The reversed semiconductor wafer is transferred successively to the primary and secondary cleaning devices 55 and 57, and the spinning drier 59, whereby the semiconductor wafer is cleaned by cleaning liquid such as pure water and dried. The spinning drier 59 may have a function of cleaning and drying. The cleaned and dried semiconductor wafer is finally returned to the cassette 65 by the workpiece conveying robot 53.

After the semiconductor wafer is polished, the dressing tool 39 of the dressing unit 41 is angularly moved over the turntable 33 as indicated by the dot-and-dash-line arrow, and then presses the dressing tool 39 against the polishing surface 34 for thereby dressing the polishing surface 34. At this time, pure water is supplied as dressing liquid through the supply pipe 24 onto the polishing surface 34.

Parts of a mechanism on the top ring 35 for holding the semiconductor wafer, the dresser element and other parts on the dressing tool 39 are expendable parts. These expendable parts of the top ring 35 and the dressing tool 39 are replaced with new parts while the top ring 35 and the dressing tool 39 are in their respective maintenance positions shown in FIG. 1. Since these maintenance positions are located closely to the side face A, the parts can easily be replaced from the side face A while the door for maintenance is being open.

The polishing cloth 21 which provides the polishing surface 34 of the turntable 33 is also an expendable part and can easily be replaced by the person for maintenance from the side face A while the door for maintenance is being open.

Cleaning brushes, sponge elements, and other parts of the primary and secondary cleaning devices 55, 57, and parts of the spinning drier 59 are also expendable parts, and can easily be replaced from the side face A' while the door for maintenance is being open.

As described above, the first embodiment of the present invention offers the following advantages:

Since the side faces A and A' are aligned or lie flush with each other, the person for maintenance is required to move not a large distance but a short distance from one of the side faces A, A' to the other, while carrying tools and parts, when a plurality of parts units or machines are to be maintained for parts replacement. Therefore, the person for maintenance finds it easy to replace plural expendable parts.

The other side faces than the side faces A and A' of the polishing apparatus comprising the polishing section 30 and the cleaning section 50 may be positioned closely to hindering objects such as walls or pillars. As a consequence, the installation space required to install the polishing apparatus therein may be relatively small in size.

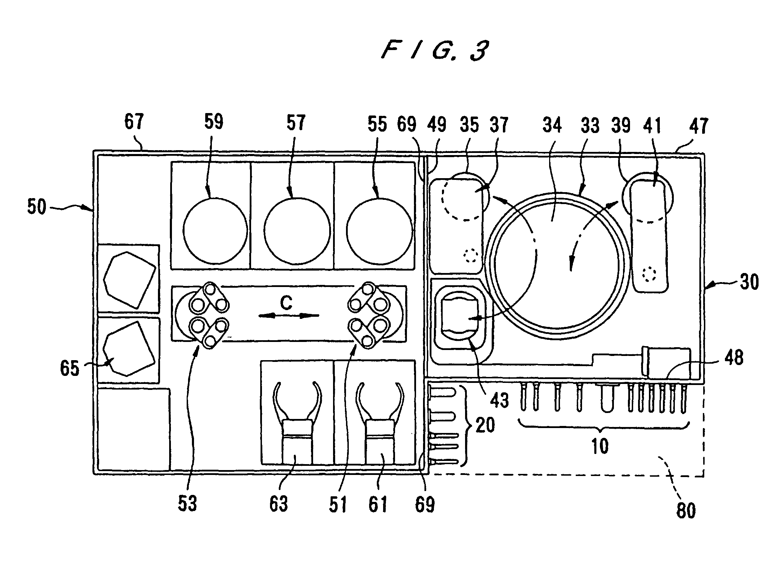

Next, a polishing apparatus according to a second embodiment of the present invention will be described below with reference to FIG. 3 through 6. In FIGS. 3 through 6, the parts which are structurally or functionally identical to the parts shown in FIGS. 1 and 2 are represented by the same reference numerals.

The structure of the polishing section 30 and the cleaning section 50 in the second embodiment is identical to that of the polishing section 30 and the cleaning section 50 in the first embodiment.

As shown in FIG. 3, in this embodiment, the chambers 47 and 67 which accommodate the various units and machines of the polishing section 30 and cleaning section 50, have respective side faces 49 and 69 joined to each other.

The side face 69 of the chamber 67 is longer than the side face 49 of the chamber 47, and hence includes an exposed portion which does not face the side face 49 of the chamber 47. An elongated rectangular space 80 indicated by the dotted line in FIG. 3 is provided in front of the exposed portion of the side face 69 and alongside of other side face 48 of the chamber 47, for accommodating a collection of pipes projecting from the chambers 47 and 67.

In other words, the units and machines of the polishing section 30 and the cleaning section 50 are positioned in the chambers 47, 67 in order to make the side faces 49, 69 different in length from each other for thereby providing the space 80.

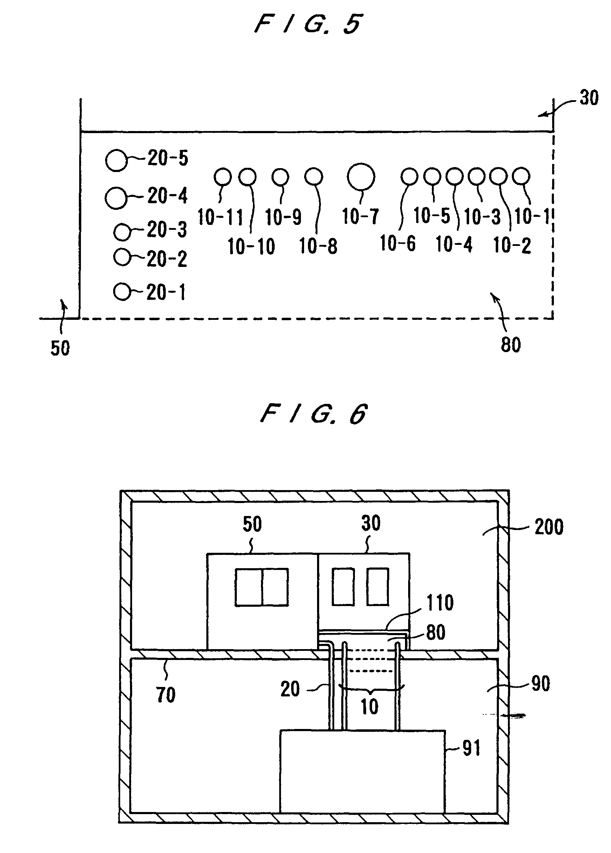

Pipes 10 (10-1 - 10-11 in FIG. 5) extending outwardly from the polishing section 30 project horizontally from the side face 48 of the chamber 47 into the space 80, and pipes 20 (20-1 - 20-5 in FIG. 5) extending outwardly from the cleaning section 50 project horizontally from the exposed portion of the side face 69 of the chamber 67 into the space 80. That is, the pipes 10 and 20 are collected in the space 80.

The pipes 10 and 20 then extend vertically through holes defined in a floor 70 (see FIG. 6) into a machinery room 90 below the floor 70 of a clean room 200 which accommodates the polishing section 30 and the cleaning section 50. The machinery room 90 houses various machines 91.

FIG. 5 shows in an enlarged scale the pipes 10-1 - 10-11 and the pipes 20-1 - 20-5 which are positioned in the space 80 and extend vertically through the floor 70.

In FIG. 5, the pipes 10-2, 10-4 and 10-6 serve as inlets of abrasive liquid circulation pipes for supplying the abrasive liquid from the machines 91 to the polishing surface 34 of the turntable 33. The pipes 10-1, 10-3 and 10-5 serve as outlets of the abrasive liquid circulation pipes for returning the abrasive liquid which has not been used to the machines 91. The pipe 10-7 serves as an abrasive liquid drain pipe for draining the abrasive liquid which has been used on the abrasive surface 34 and also draining pure water. The pipe 10-8 serves as a pure water supply pipe for supplying pure water for dressing process. The pipe 10-9 serves as a leakage liquid drain pipe for draining liquid which has leaked from the various units of the polishing section 30. The pipe 10-10 serves as an outlet of a cooling water circulation pipe for supplying cooling water to the turntable 33 or the like. The pipe 10-11 serves as an inlet of the cooling water circulation pipe.

The pipe 20-1 serves as a pure water supply pipe for supplying pure water to the primary and secondary cleaning devices 55, 57, the spinning drier 59 and the workpiece reversing device 61. The pipes 20-2, 20-3 serve as drain pipes for draining various liquid which has been used. The pipe 20-4 serves as an inlet of a cleaning liquid circulation pipe for supplying cleaning liquid to the primary and secondary cleaning devices 55, 57. The pipe 20-5 serves as an outlet of the cleaning liquid circulation pipe.

FIG. 6 shows an arrangement of the polishing apparatus and the machinery room 90. As shown in FIG. 6, the polishing apparatus is installed in the clean room 200. The machinery room 90 is disposed below the floor 70 on which the polishing apparatus is installed. The various machines 91 housed in the machinery room 90 include an abrasive liquid supply device for supplying and circulating the abrasive liquid to the polishing section 30, a waste liquid treatment device for treating waste liquid discharged from the polishing section 30 and the cleaning section 50, and a cooling water supply device for supplying the cooling water to the polishing section 30.

The pipes 10, 20 extending downwardly through the floor 70 into the machinery room 90 are connected to the machines 91 in the machinery room 90. The pipes 10, 20 which project from the polishing section 30 and the cleaning section 50 at the side faces 48, 69 of the chambers 47, 67 are collected in the space 80. These pipes 10, 20 do not project from other side faces of the polishing section 30 and the cleaning section 50, and hence maintenance of the polishing section 30 and the cleaning section 50 can be easily performed at those other side faces.

Since the space 80 is positioned at a recess jointly defined by the side faces 48, 69 of the chambers 47, 67, the pipes 10, 20 do not project into passages around the polishing section 30 and the cleaning section 50.

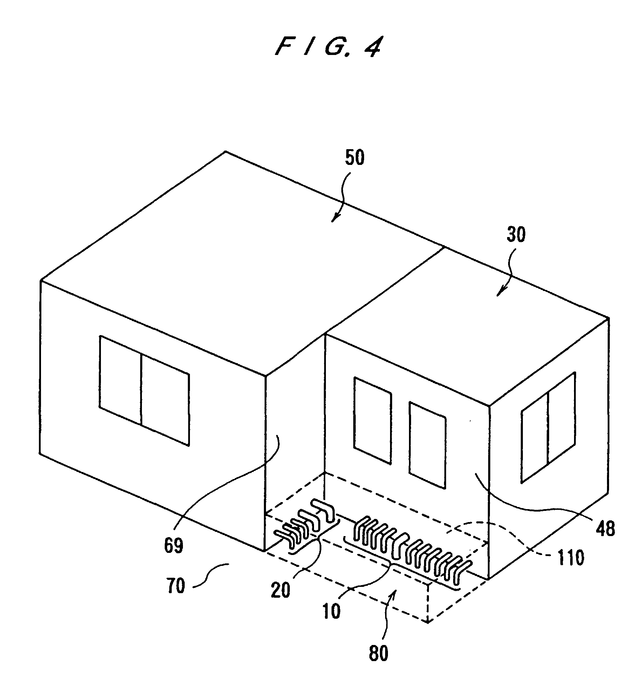

As shown in FIGS. 4 and 6, the projecting pipes 10, 20 in the space 80 may be covered with a step-like plate 110. The step-like plate 110 thus mounted in position may be used as a footstep, thus providing a space thereabove as a free space available for some purposes, e.g., for maintenance of the polishing section 30. The step-like plate 110 is also effective to conceal the pipes 10, 20 from external view, thus providing a sightly appearance.

As is apparent from the above description, the second embodiment of the present invention offers the following advantages:

Since the pipes from the polishing section and the cleaning section are collected at a single location, maintenance for various devices in the polishing section and the cleaning section can be easily performed from other side faces where the pipes do not exist.

Since the pipes from the polishing section and the cleaning section are collected at a single location, the pipes do not present obstacles when the polishing apparatus is transported. Further, the through holes for inserting the pipes into the downstairs machinery room can be formed at a single location, and thus the installation work of the polishing apparatus can be easily carried out.

Since the space for collecting the pipes is provided at a recess jointly defined by the polishing section and the cleaning section, the pipes do not project into passages around the polishing section and the cleaning section, and hence do not obstruct operators walking therearound.

In the case where the step-like plate is provided in the space for collecting the pipes, a space above the step-like plate can be utilized as a free space available for some purposes, and the step-like plate can conceal the pipes from external view to thus provide a sightly appearance.

In the above embodiment, although the polishing apparatus comprises a polishing section and a cleaning section housed in each chamber, the partition between two sections may be omitted. That is, the polishing section and the cleaning section may be housed in a common housing.

Although a certain preferred embodiment of the present invention has been shown and described in detail, it should be understood that various changes and modifications may be made therein without departing from the scope of the appended claims.

## Claims

1. A polishing apparatus for polishing a surface of a workpiece, said apparatus comprising:
turntable (33) having a polishing surface (34);
a top ring (35) for holding a workpiece and for pressing the workpiece against said polishing surface (34) of said turntable (33) to polish the workpiece, said top ring (35) being movable to a first maintenance position whereat maintenance can be performed thereon;
a dressing tool (39) for dressing said polishing surface (34) of said turntable (33), said dressing tool (39) being movable to a second maintenance position whereat maintenance can be performed thereon;
a first chamber (47) having a plurality of side faces including a first side face (A) serving as a first maintenance face; **characterized by**
said turntable (33), said top ring (35) and said dressing tool (39) being located within said first chamber (47) at relative positions such that said polishing surface (34) of said turntable (33), said top ring (35) when in said first maintenance position thereof and said dressing tool (39) when in said second maintenance position thereof are positioned closely adjacent said first maintenance face (A), thereby enabling access for maintenance purposes from said first maintenance face (A) to all of said polishing surface (34) of said turntable (33), said top ring (35) when in said first maintenance position thereof and said dressing tool (39) when in said second maintenance position thereof.

2. An apparatus as claimed in claim 1, further comprising a second chamber (67) having a plurality of side faces including a one side face (A') serving as a second maintenance face and oriented to extend in the same direction as said first maintenance face (A), and a cleaning device (55, 57, 59) for cleaning a workpiece that has been polished, said cleaning device (55, 57, 59) being located within said second chamber (67) at a position closely adjacent said second maintenance face (A'), thereby enabling access for maintenance purposes from said second maintenance face (A') to said cleaning device (55, 57, 59).

3. A polishing apparatus for polishing a surface of a workpiece, said apparatus comprising:
a housing having a plurality of sides;
a polishing section (30) housed in said housing for polishing a surface of a workpiece;
a cleaning section (50) housed in said housing for cleaning a workpiece that has been polished; **characterized by**
a single outer side (A, A') of said housing providing direct access into an interior of said housing sufficient for achieving maintenance of both said polishing section (30) and said cleaning section (50).

## Patentansprüche

1. Eine Poliervorrichtung zum Polieren einer Oberfläche eines Werkstücks, wobei die Vorrichtung folgendes aufweist:
einen Drehtisch (33) mit einer Polieroberfläche (34);
einen oberen Ring (Oberring) (35) zum Halten eines Werkstücks und zum Pressen eines Werkstücks gegen die Polieroberfläche (34) des Drehtischs (33) zum Polieren des Werkstücks, wobei der Oberring (35) in eine erste Wartungsposition bewegt werden kann, wobei darin eine Wartung ausgeführt werden kann;
ein Aufbereitungs- bzw. Dressingwerkzeug (39) zum Aufbereiten der Polieroberfläche (34) des Drehtischs (33), wobei das Aufbereitungswerkzeug (39) in eine zweite Wartungsposition bewegt werden kann, wo die Wartung daran ausgeführt werden kann;
eine erste Kammer (47) mit einer Vielzahl von Seitenstirnflächen einschließlich einer ersten Seitenstirnfläche (A), die als eine erste Wartungsstirnfläche dient, **dadurch gekennzeichnet, dass** der Drehtisch (33), der Oberring (35) und das Aufbereitungswerkzeug (39) innerhalb der ersten Kammer (47) angeordnet sind, und zwar an relativen Positionen derart, dass die Polieroberfläche (34) des Drehtischs (33), der Oberring (35), wenn er sich in der ersten Wartungsposition befindet, und das Aufbereitungswerkzeug (39), wenn es sich in der zweiten Wartungsposition befindet, dicht benachbart zu der ersten Wartungsstirnfläche (A) positioniert sind, wodurch der Zugang oder Zugriff für Wartungszwecke von der ersten Wartungsstirnfläche (A) aus ermöglicht wird, und zwar zu allen der erwähnten Polieroberfläche (34) des Drehtischs (33), dem Oberring (35), wenn dieser sich in der ersten Wartungsposition befindet, und dem Aufbereitungswerkzeug (39), wenn dieses sich in der erwähnten zweiten Wartungsposition befindet.

2. Vorrichtung nach Anspruch 1, wobei ferner eine zweite Kammer (67) vorgesehen ist, und zwar mit einer Vielzahl von Seitenstirnflächen einschließlich einer Seitenstirnfläche (A'), die als eine zweite Wartungsstirnfläche dient und orientiert ist zur Erstreckung in der gleichen Richtung wie die erste Wartungsstirnfläche (A), und
einer Reinigungsvorrichtung (55, 57, 59) zum Reinigen eines Werkstücks, das poliert ist, wobei die Reinigungsvorrichtung (55, 57, 59) innerhalb der zweiten Kammer (67) angeordnet ist, und zwar an einer Position dicht benachbart zur zweiten Wartungsstirnfläche (A'), wodurch der Zugriff für Wartungszwecke von der erwähnten zweiten Wartungsstirnfläche (A') zu der Reinigungsvorrichtung (55, 57, 59) ermöglicht wird.

3. Poliervorrichtung zum Polieren einer Oberfläche eines Werkstücks, wobei die Vorrichtung folgendes aufweist:
ein eine Vielzahl von Seiten aufweisendes Gehäuse;
einen Polierabschnitt (30), untergebracht in dem Gehäuse zum Polieren einer Oberfläche eines Werkstücks;
einen Reinigungsabschnitt (50), untergebracht in dem erwähnten Gehäuse zum Reinigen eines Werkstücks, das poliert ist, **gekennzeichnet dadurch, dass** eine einzige Aussenseite (A, A') des Gehäuses den direkten Zugriff in das Innere des Gehäuses vorsieht, und zwar ausreichend zur Erreichung der Wartung von sowohl dem Polierabschnitt (30) als auch dem Reinigungsabschnitt (50).

## Revendications

1. Appareil de polissage pour polir une surface d'une pièce à usiner, ledit appareil comprenant :
une plaque tournante (33) comportant une surface de polissage (34) ;
un anneau supérieur (35) pour maintenir une pièce à usiner et pour appuyer la pièce à usiner contre ladite surface de polissage (34) de ladite plaque tournante (33) pour polir la pièce à usiner, ledit anneau supérieur (35) étant mobile vers une première position de maintenance dans laquelle une maintenance peut être effectuée sur celui-ci ;
un outil de dressage (39) pour dresser ladite surface de polissage (34) de ladite plaque tournante (33), ledit outil de dressage (39) étant mobile jusqu'à une seconde position de maintenance dans laquelle une maintenance peut être effectuée sur celui-ci ;
une première chambre (47) possédant une pluralité de faces latérales comportant une première face latérale (A) servant de première face de maintenance ; **caractérisé par**
**le fait que** ladite plaque tournante (33), ledit anneau supérieur (35) et ledit outil de dressage (39) sont situés dans ladite première chambre (47) dans des positions relatives telles que ladite surface de polissage (34) de ladite plaque tournante, ledit anneau supérieur (35) lorsqu'il est dans sa dite première position de maintenance et ledit outil de dressage (39) lorsqu'il est dans sa dite seconde position de maintenance, sont positionnés précisément à côté de ladite première face de maintenance (A), de façon à permettre l'accès à des fins de maintenance à partir de ladite première face de maintenance (A) à l'ensemble de ladite surface de polissage (34) de ladite plaque tournante (33), audit anneau supérieur (35) lorsqu'il est dans sa dite première position de maintenance et audit outil de dressage (39) lorsqu'il est dans sa dite seconde position de maintenance.

2. Appareil selon la revendication 1, comprenant en outre une seconde chambre (67) possédant une pluralité de faces latérales comportant une première face latérale (A') servant de seconde face de maintenance et orientée pour se prolonger dans la même direction que ladite première face de maintenance (A) et un dispositif de nettoyage (55, 57, 59) pour nettoyer une pièce à usiner ayant été polie, ledit dispositif de nettoyage (55, 57, 59) étant situé dans ladite seconde chambre (67) dans une position précisément adjacente à ladite seconde face de maintenance (A'), de manière à permettre l'accès à des fins de maintenance à partir de ladite seconde face de maintenance (A') audit dispositif de nettoyage (55, 57, 59).

3. Appareil de polissage pour polir une surface d'une pièce à usiner, ledit appareil comprenant :
un logement possédant une pluralité de faces ;
une section de polissage (30) logée dans ledit logement pour polir une surface d'une pièce à usiner ;
une section de nettoyage (50) logée dans ledit logement pour nettoyer une pièce à usiner ayant été polie ; **caractérisé par**
une face externe unique (A, A') dudit logement donnant un accès direct à l'intérieur dudit logement, suffisant pour effectuer une maintenance à la fois de ladite section de polissage (30) et de ladite section de nettoyage (50).
